# EUROPEAN PATENT SPECIFICATION

(11) **EP 3 043 221 B1**
(45) Date of publication and mention of the grant of the patent: **28.02.2018**
(21) Application number: 15202019.4
(22) Date of filing: 22.12.2015
(51) Int. Cl.: G05B 19/05, H01H 9/16, H03K 17/968

(54) **BUS POWERED MANUALLY ACTUABLE CONTACT AND COMMUNICATION MODULE**
MANUELL BETÄTIGBARES KONTAKT- UND KOMMUNIKATIONSMODUL MIT STROMVERSORGUNG VOM BUS
MODULE DE CONTACT ET DE COMMUNICATION POUVANT ÊTRE ACTIONNÉ MANUELLEMENT ET ÉTANT ALIMENTÉ PAR UN BUS

(30) Priority: 09.01.2015 SE 1550015
(43) Date of publication of application: 13.07.2016
(73) Proprietor: Carlsson, Leif, 791 62 Falun (SE)
(72) Inventor: Carlsson, Leif, 791 62 Falun (SE)
(74) Representative: Bergenstråhle Group AB

(56) References cited:
- EP-A1- 0 740 843
- WO-A1-97/34310
- US-A1- 2012 182 698
- Anonymous: "AS-Interface - Wikipedia, the free encyclopedia", , 31 May 2016 (2016-05-31), pages 1-8, XP055276738, Retrieved from the Internet: URL:https://en.wikipedia.org/wiki/AS-Inter face [retrieved on 2016-05-31]

## Description

### Technical field

The present invention relates to automation and control devices, and particularly to bus powered modules and communication modules employing a shared common communications link to activate an output device, and a method of making such modules.

### Background

Systems for remotely controlling electrical devices from a manual control panel are well known. In some systems employing point-to-point input/output or I/O architecture, each of a plurality of manually activated operator interface devices, such as a pushbutton, a key operator, a joy stick, or a rotary selector, can be used to operate an associated contact block having one or more electrical switches. Each contact block is electrically connected to an associated remotely located output device, such as a pilot light, a contactor, an overload relay, or other electrically controllable devices.

These individual point-to-point connections between each contact block and its associated output device causes the task of making a manual control panel assembly to become extremely labour intensive and costly. In order to reduce the labour costs for setting up the control panel at site, as well as the cost of materials, it is now known to construct manual control panel assemblies, wherein a number of operator interface controlled contact blocks are connected to a number of remotely located output devices by a single time division multiplexing communications link shared by all of the input and output modules of the system. In this system, each contact block is electrically connected to an associated input access module, which provides access to the multiplexing communications link over which the status of that particular contact block is conveyed to an associated output access control module. The output access control module is electrically connected to an associated output device, which is ultimately controlled by the associated operator interface device at the control panel.

It is also known to convey contact block status information and input access module mode status between a number of input access modules and their associated output access modules via network signalling.

The use of some types of distributed I/O architecture will eliminate the point-to-point wiring between each contact block and its associated output device. However, in the current state of the art, a point-to-point connection is still required between the contact block and some type of input access module associated with the contact block, and between the output device and some type of output access module associated with the output device. Each connection between an access module and a contact block or output device requires at least two separate wires and sometimes more. In control panel construction, the operator interface device is installed on the outside of the panel cover, and the contact block is on the inside of the panel cover. The operator interface device and the contact block are in communication with each other, in such a way that manually operating the operator interface device will change the state of the electrical switches within the contact block. The input access module is generally placed at an easily accessible location inside the control panel, such as the back wall of the panel enclosure. This is usually some distance away from the contact block. It is also common for a control panel to include a number of pilot lights, each indicating the status of an associated output device controlled by its associated operator interface device.

These pilot lights are actually output devices and therefore require a connection to the common communications link. Each pilot light requires a separate output access module and wiring between the output access module and the pilot light. The wiring between the contact blocks, pilot lights, and their associated input and output access modules must be of sufficient length to permit cover removal when inspection, maintenance, or trouble shooting is required. This generally requires several feet of wire for each connection. Control panels, which have a large number of operator interface devices and pilot lights, are difficult to wire and assemble due to the many wires required. Thus, even with the common communications link between input access modules and output access modules, the control panel itself still requires considerable wiring time and material. The physical size of the control panel enclosure is also a consideration. For each contact block and pilot light in the control panel, one input or output access module is required. The input and output access modules are at least the same size as the contact blocks and pilot lights, and in many cases much larger. Therefore, the volume of the control panel must be of sufficient size to enclose all of the input and output access modules and the wire required for connecting them to their respective contact blocks and pilot lights.

Although control panels today often have displays and touch panels, conventional pushbuttons, switches, and light indicator are very important. It is labour intensive and time consuming to adjust and connect them to the control systems e.g. PLC - Programmable Logic Controller etc., even if modern bus technology is used as Actuator Sensor Interface systems.

US 2012/0182698 A1 discloses an assembly for installing building systems engineering units including a housing and a control device for carrying out an electronic function and a base module designed for fastening the housing for a pre-determined installation situation. The output devices controlled by the assembly are simple actuators for home devices and lack any advanced functionality.

It is therefore desired to overcome these problems, and also to provide a simplified connector arrangement that enables at least one electrical switch to be connected to a slave unit with a communication module in a versatile and uncomplicated manner.

### Summary

The main objective of this invention is to provide solutions to problems related to the labour intensive wiring and assembly problems associated with control panels, while at the same time making trouble-shooting and maintenance of the control panels easier, especially for adjusting and connecting manual switch operator devices e.g. pushbuttons, rotary selectors, key operators, switches, and light indicators to the control panels.

It is an object of the invention to transmit a manually actuatable movement from the hand to a signal to a PLC - Programmable Logic Controller or PC - Personal Computer or a Microcomputer, and a signal from the PLC or PC to a visual signal to the eye.

It is also an object of this invention to reduce the number of components required for the control panels, by reducing the need of electrical circuits, logic circuits, and mechanical parts.

Further it is an object to make the control panels flexible, by making it possible to connect different types of manual switch operator devices to the control panels, without requiring additional labour and components.

Further it is an object to use components that do not wear out easily, so the control panels are durable.

Further it is an object to make the production of the parts of the control panels cheap.

Further it is an object to be able to connect switch operator devices that have multi position actuators, which is not possible in today's control panels.

Other features and advantages of the invention will become apparent to those skilled in the art upon review of the following detailed description, claims, and drawings.

According to an aspect of the invention a system comprising at least one output device and a manually actuatable integrated unit module is provided. The manually actuatable integrated unit module comprises: a first printed circuit board comprising: a switch operator device movable between at least a first and a second position; at least a first electrical switch, mounted on the surface of the first printed circuit board in such a way that movement of said switch operator between said at least first and second position will cause a change in mode of said at least first electrical switch; and such a change of mode will cause a control signal to be transferred via a common communications link associated with the manually actuatable unit module for controlling the at least one output device; and, a second printed circuit board comprising at least one Actuator Sensor Interface slave module mounted on the second printed circuit board, the second printed circuit board is arranged for handling a first printed circuit board, said second printed circuit board having inputs for receiving signals from said at least first electrical switch on said first printed circuit board, and also having outputs for transmitting signals from the slave module to output means on said first printed circuit board, where the inputs are arranged to handle at least a 4-bit word, and where the outputs are arranged to handle at least a 4-bit word, wherein said change of mode of said at least first electrical switch, activating said at least one slave module in such a way that said control signal on said associated common communications link is produced, is adapted to control said at least one output device, and in that said at least one slave module is connected to said at least one output device, wherein said output device is a master module in a control system, such as a Programmable Logic Controller or a Microcomputer controlling in a pre-determined and cyclic way said at least one slave module.

At least one communication terminal being a slave module for an Actuator Sensor Interface is mounted on a second printed circuit board that is arranged for handling any first printed circuit board. The second printed circuit board has inputs for receiving signals from said at least first electrical switch on said first printed circuit board , and also has outputs for transmitting signals from the communications terminal to output means on said first printed circuit board. The inputs are arranged to handle at least a 4-bit word, and the outputs are arranged to handle at least a 4-bit word. Said change of mode of said at least first electrical switch, activating said at least one communication terminal in such a way that said control signal on said common communications link is produced, is adapted to control said associated output device. The output device is a master module in a control system, such as a Programmable Logic Controller or a Microcomputer controlling in a pre-determined and cyclic way said at least one slave module.

A particular advantage of the present invention is that the second printed circuit board can be produced in a standardized way, which is cost effective and smart, while the first printed circuit board can be custom made dependant on the manually operable actuators, e.g. pushbutton operators, rotary selectors, key operators, switches, indicators, handles, knobs, joysticks and light indicators that are to be connected to the switch operator device.

Another important advantage is that the present invention provides versatility since at least four inputs and at least four outputs are used for communiation between the first printed circuit board and the second printed circuit board, enabling at least 16 different states to be communicated via the inputs and at least 16 different states to be communicated via the outputs. In this way, the first printed circuit board is enabled to be equipped with electrical switches and output means that each can handle at least 16 different states.

According to another example, said common communications link is an Actuator Sensor Interface bus.

According to another example, the switch operator device includes a manually operable actuator such as e.g. a button with a digital display, a manually operable selector switch, a manually operable key switch, or a manually operable pushbutton.

According to another example, the manually operable actuator includes a pilot light, having a light being determined by said associated output device.

According to another example, said switch operator device is connected to a manually operable actuator that comprises an indicator.

According to another example, the manually actuatable integrated unit module comprises a rotatable switch knob which can be turned in fixed steps, an encoder plate, adapted to be mechanically movable with the rotatable switch knob, and a partially enclosing encoder device. The encoder device is arranged to interpret the position of the encoded plate and thus the setting of the switch knob when the switch knob is turned.

Other examples are disclosed in the dependent claims.

According to another aspect of the invention, a method for making a system comprising at least one output device and a manually actuatable integrated unit module is provided according to claim 13.

### Brief description of the drawings

In the following, the invention will be described more closely with reference to an example of an embodiment shown in the attached drawings. The different aspects of the invention, and especially the features and advantages thereof, will easily be understood on the basis of the description and drawings, in which:Fig. 1 is a front view of a control panel, having manually activated operator interface devices, according to prior art.Fig. 2 is a manually actuated control and signal system (Schneider Electric system XB4), according to prior art.Fig. 3 is a switch operator device, according to prior art.

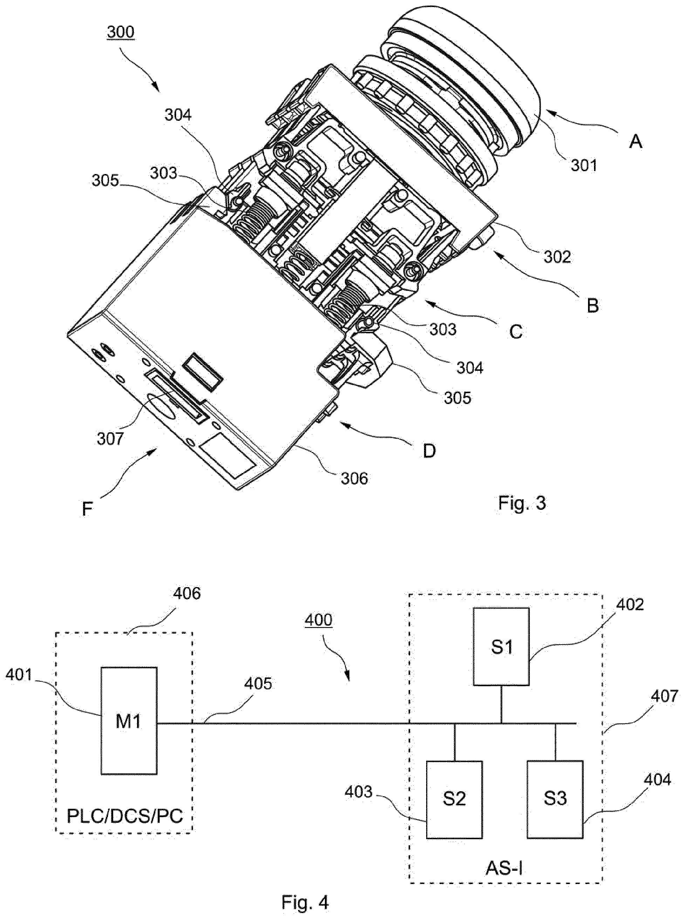

Fig. 4 is a block diagram of an Actuator Interface bus system, according to prior art.

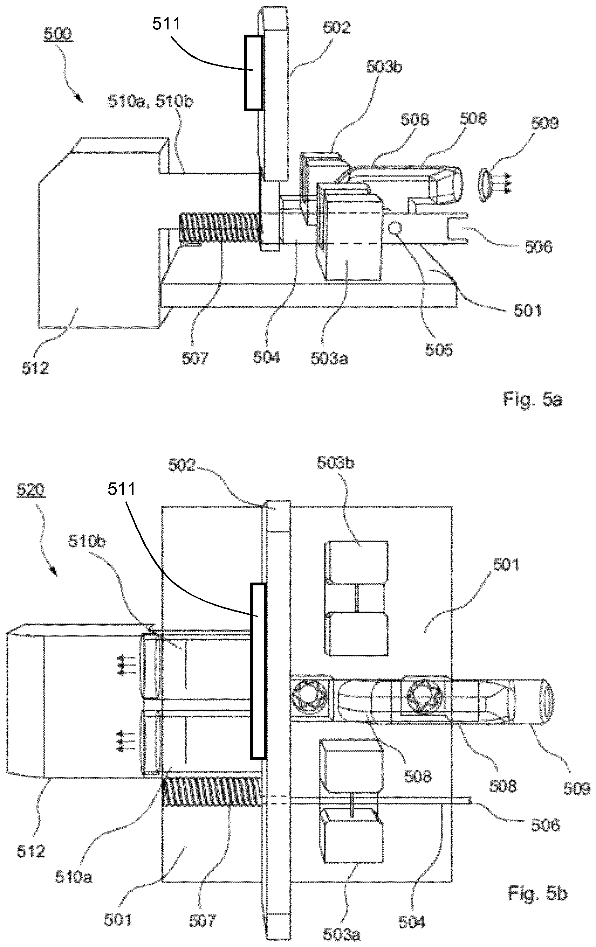

Fig. 5a-b is a front and top view of an embodiment of the unit module, according to the invention.

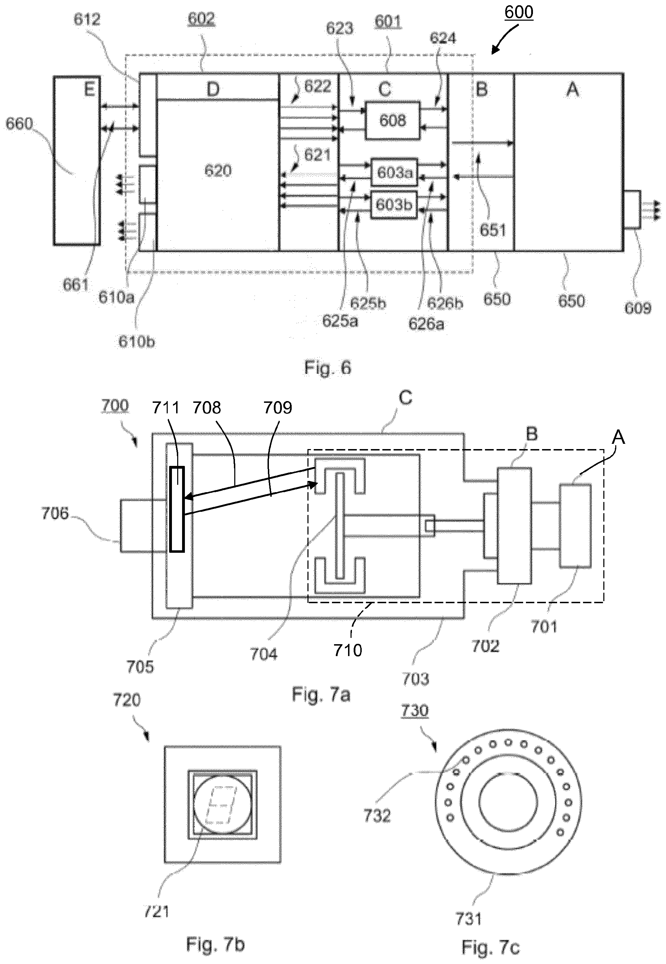

Fig. 6 is a block diagram of the embodiment of the unit module in Fig. 5a-b, according to the invention.
Fig 7a-c is an extended use of an embodiment of the unit module, according to the invention.

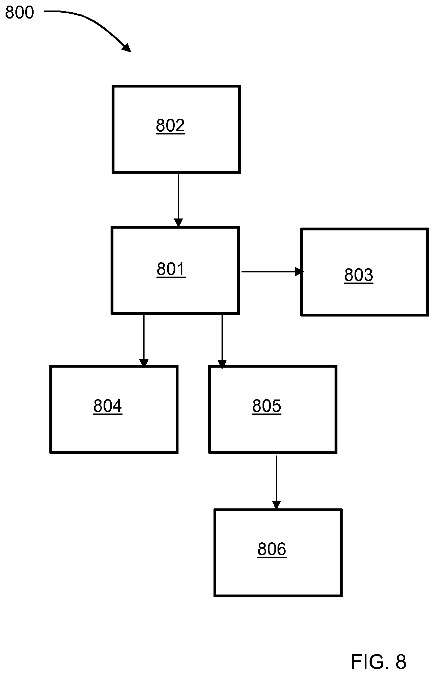

Fig 8 is a block diagram of an Actuator Interface bus system for the present invention,

### Detailed description

Before one embodiment of the invention is explained in detail, it is to be understood that the invention is not limited in its application to the details of construction and description as illustrated in the drawings. The invention is capable of other embodiments and of being practiced or carried out in various other ways. Also, it is to be understood that the phraseology and terminology used herein is for the purpose of description and should not be regarded as limiting.

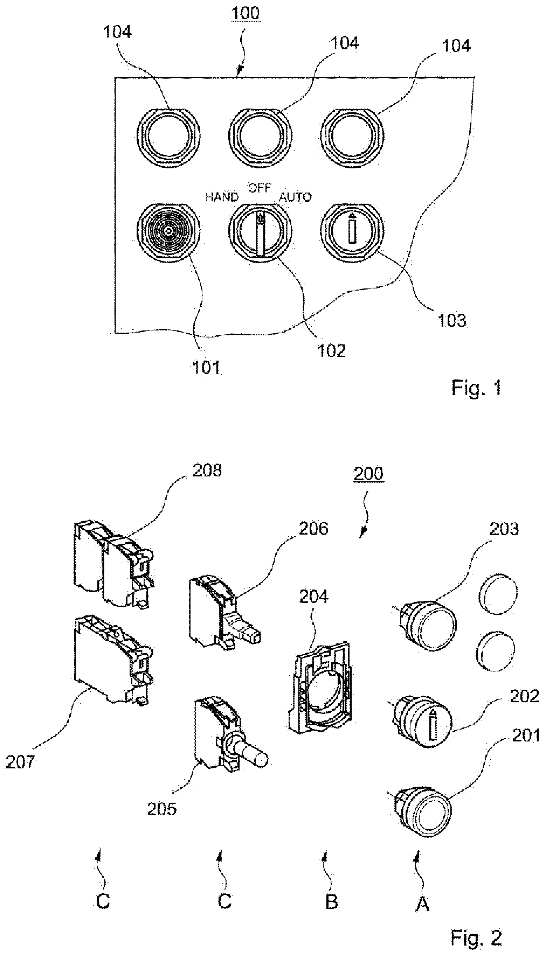

Referring to **Fig.1****,** it can be seen that a typical control panel assembly, as generally indicated by reference numeral 100, includes a number of manual switch operator devices, such as a pushbutton operator 101, a rotary selector 102, or a key operator 103. These switch operator devices manually interface with contact blocks, which provide the means to control a number of output devices at locations remote from the control panel assembly 100. It is also common for the control panel assembly 100 to include a number of output devices, for example, pilot lights 104, which normally indicate the status of associated remotely located output devices controlled by the switch operator devices.

Referring to **Fig. 2****,** a known control and signalling unit 200 from Schneider Electric is shown, comprising pushbuttons 201, switches 202, LED indicators 203 as pilot lights designed for visual signalling all in module A, holders 204 in module B, indication/LED 205, 206 in module C, and contact blocks 207, 208 in module C. According to the invention, an embodiment of a new module, herein defined as a unit module, will replace module C, i.e. the indications/LED 205, 206 and indication lamp/LED contact blocks 207, 208, and further extend the functionality of the module A and B, i.e. the holder 204, the pushbuttons 201 and switches 202 that are mechanically transforming the power of the hand to the unit module, and the LED indicators 203 that transform visual signals from the unit module to the eye.

Referring to **Fig. 3****,** there is shown a known example of the switch operator device 300 with a pushbutton, which is detachably connected to a communications terminal 306 for the purpose of a bus connection. The communications terminal 306 has a logic unit for electrically connecting the control and/or indication device to the bus system. Further, a mechanical connecting means 305, for detachably fixing the communications terminal 306 to two functional elements 304, and electrical connecting means 303, providing the electrical contact between the communication terminal 306 and the two functional elements 304. A common communications link 307, electrically connecting the communication terminal 306 to remotely located output devices controlled by the switch operator via the bus system.

The manual switch operator device 301 in **Fig. 3****,** shown as a pushbutton/switch/indicator 201, 202, 203, in **Fig. 2****,** is divided into four modules.
A: The control and/or the indicating module 301 (e.g. pushbutton with/without indicator knob with/without display, joystick, etc.).
B: The Bezel or Holder module 302 that holds together parts A and C, and attach ABC in e.g. a panel cover front plate.
C: The switch module that switches open or close an electrical switch.
D: The control module, herein defined as the slave, connected by wire to the master module in the control system (PLC - Programmable Logic Controller or PC - Microcomputer), here not shown. By the electrical connecting means 303 module D is pressed to module C and thus linked to the control module A by using module C.

According to the invention, an aspect of the embodiment of the unit module is designed to replace module C and extend the functionality of the modules A and B to include module D. It is a new solution that optimizes wiring and assembly of manually operable switch operators, such as manual actuators to control panels, and extends the possibility to connect different manually operable switch operators and especially multiple switches of different types the same way to existing manual control panels for remotely controlling electrical devices and other types of indicators.

Referring to **Fig. 4****,** there is shown a known Actuator Sensor Interface system 400, the Actuator Sensor Interface, herein defined as AS-interface or AS-I. A controller 406 e.g. PLC - Programmable Logic Controller, DCS - Distributed Control System, or a PC (Micro Computer), handling at least one master (M1) 401 controlling the AS-I slaves (S1-S3) 402-404 in the AS-I slave network 407. The AS-I slave network 407 is configured and controlled by the master M1 401 that is the interface between the controller 406 and the AS-I slave network 407. The master M1 401 continually exchanges information with all slaves S1-S3 402-404 linked to the AS-I bus 405, herein defined as the common communications link, and the controller 406 in a pre-determined and cyclic way. Thereby can the controller 406 have contact with all sensors and control all actuators connected in the AS-I system 400. Further down below it is shown how such an AS-I slave network 407 can be incorporated into embodiments of the unit module, according to the invention, as it is a simple and cheap industrial networking solution. As the person skilled in the art appreciates, other interfaces than AS-I slave networks 407 for industrial networking solutions can be used in the embodiments of the unit model, according to the invention, but can be more complex and expensive.

AS-I reduces operating costs and offers great flexibility for all automation systems. Slaves are managed by a single master M1 401 that interrogates each slave S1-S3 402-404 present on the common communications link 405 in turn and waits for its response. The amount of slaves to be mounted to a master is about 62 and each slave has its own address. The master M1 401 is query cycling and each slave S1-S3 402-404 is defined by its functions included in the slave, where, according to some aspects, the maximum number of on/off inputs/outputs per slave is four inputs and four outputs.

Alternatively, there may of course be more than said four inputs and four outputs. The number of remotely located output devices connectable to one AS-I master M1 401 is up to 248 sensors and 248 actuators by two unshielded wires, carrying the power supply for peripherals and logical signals. In most case a controller 406 can handle more than one AS-I master M1 401.

The AS-Interface slave network 407 is a networking alternative to the hard wiring of field devices. The AS-Interface slave network 407 can also be used as a partner network for higher level field bus networks such as Profibus, ProfiNet, and Industrial Ethernet, for whom it offers a low-cost remote input/output solution. According to the invention, in such a case a gateway is involved or a master module is a distributed module in Profibus, ProfiNet, and Industrial Ethernet node. AS-I is used in automation applications, including conveyor control, packaging machines, process control valves, bottling plants, electrical distribution systems, airport baggage carousels, elevators, bottling lines, and food production lines. The name Actuator Sensor Interface (AS-I) represents its own concept. Although technically meaning a bus, the term interface shows that it provides a simple program for accessing field sensors and actuators. Traditionally, these connections are made of twisted pairs that connect each actuator and sensor, one by one, to the corresponding controller, typically a PLC.

Referring to **Fig. 5a** and **Fig. 5b****,** an embodiment of the unit module 500, 520, according to the invention is shown from the side 500 and the top 520. This exemplary embodiment of the unit module 500, 520, according to the invention can be used for direct replacement of today's control and signalling system, e.g. Schneider Electric Harmony XB4, the module described in **Fig. 2****.** In the example of Schneider Electric Harmony XB4 module, at least four different components can be replaced by the new unit module 500, 520.

The unit module 500, being in the form of a connector arrangement, comprises a first circuit board 501 and a second circuit board 502, herein defined as daughter card 501 and main card 502, respectively. On the main card 502 a communications terminal 511 is mounted, connected to a common communications link 512. According to some aspects, the communications terminal 511, is an AS-I slave module 511 in an AS-Interface slave network 407 as shown in Fig. 4.

The status of the communications terminal 511 is shown by the status indicator 510a-b, according to the AS-I standard, e.g. at least one LED indicator indicates the bus status/ the status of the unit module (the status if active bus, the status if bus is addressed, and status if voltage is supplied). The daughter card 501 comprises at least one electrical switch 503a that is controlled by a manual rod device 504 with a slot 505 and handle 506, herein defined as a switch operator device 504-506. The switch operator device 504-506 is movable between at least a first and a second position. The switch operator device 504-506 can have a return spring 507. The switch operator device 504-506 is mechanically operated, e.g. by a pushbutton or switch, not shown. By pushing the pushbutton in the in-position, the switch operator device 504-506 moves to a position where the slot 505 is positioned such that the electrical switch 503a creates a signal change. The return spring 507 gives the pushbutton a resistance when pressing the button in the in-position. The same return spring 507 biases the rod 504 back in position when the pushbutton is pressed in out-position.

The change of position of the switch operator device 504-506 changes the state of the electrical switch 503a, and in turn changes the state of the level of a signal. When the pushbutton changes the state from being out to in, the state of the signal changes and e.g. the level of the signal rises. In its simplest form, the signal is no signal when the pushbutton is out and when pressed in, a signal can be detected. An example of such signal is a voltage signal. In its simplest form no signal is 0 volt, or at least no signal is e.g. between 0 and 0.2 volt, and any voltage above at least 0.5 volt during a pre-determined time is a voltage signal detected. However, as a person skilled in the art appreciates that it can be any signal that can be measured, e.g. a current, a radiation of light or magnetic/electric fields. An advantage with detecting a voltage signal, is that the signal itself does not have to be converted to a digital signal, "0" or "1", it can directly be interpreted as a signal or no signal, saving components the need for complex logic circuits for converting a voltage signal into a digital signal, "0" or "1 ", which in turn reduces production cost and reduces the size of the unit module etc.

An example of an electrical switch 503a-b is a light switch, such a light switch is e.g. a photomicrosensor, and when the slot 505 is in position for a pilot light to be detected, the voltage level rises. An example of a photomicrosensor is EE-SX1041 by Omron. For this particular photomicrosensor EE-SX1041 by Omron, the pulse width is 10 µs maximum with a frequency of 100 Hz, forward voltage 1.2 V and maximum 1.5 V. It produces an instantaneous voltage, which is the voltage between two points at a particular moment in time. As a person skilled in the art appreciates, any kind of converter for converting a mechanical movement into an electrical signal can be used, e.g. in its simplest way with a reed switch that is controlled by a moving magnet, the magnet closes the switch depending on the position of the switch operator device 504-506, and a voltage signal can be detected.

As a person skilled in the art also appreciates, the ways the pushbutton works together with the switch operator device 504-506 and the photomicrosensor 503a-b is only an example of ways the switch operator device 504-506 and photomicrosensor 503a-b can be combined. With other switch operator devices 504-506 mechanically operated by a manual actuator e.g. a joystick function, it would have to be combined differently, since a joystick function can have more than two movable positions.

The number of light switches 503a-b on the daughter card 501, as well as the number of positions that the switch operator device 504-506 is movable between, are dependent on the type of manual actuators. Further, the number of daughter cards 501 that are connected to the main card 502, as well as the features present on each daughter card, are dependent on the number of switch operator devices 504-506 as well as the type of switch operators. There is at least one switch operator device 504-506 per daughter card 501. In **Fig. 5a** and **Fig. 5b** there is shown one switch operator device 504-506 with a bias spring 507, but two light switches 503a and 503b are shown.

The daughter card 501 is adapted to handle a certain switch operator device 504-506. As an example, a manually operable actuator comprised in a switch operator device, such as e.g. a switch with 16 different positions, needs a special daughter card 501 adapted for handling all different movable positions compared to a pushbutton with only two positions. The main card 502 can handle any daughter card 501, which is in turn is adapted for a certain switch operator device 504-506 or actually in turn is adapted for the manually operable actuator, such as e.g. pushbuttons 101, rotary selectors 102, key operators 103, pilot lights 104 in **Fig. 1****,** or pushbuttons 201, switches 202, LED indicators 203 in **Fig. 2****.** The daughter card 501 is adapted for how to convert the mechanical movement of the manually operable actuator into a signal.

Thereby the main card 502 can be produced in a standardized way, which is cost effective and smart, while the daughter card 501 can be custom made dependant on the manually operable actuators, e.g. pushbutton operators 101, rotary selectors 102, or key operators 103 etc. as shown in **Fig. 1****;** or pushbutton/switch/indicator 201, 202, 203, etc. as shown in **Fig. 2****,** or handles, knobs, joysticks, light indicators that are to be connected to the switch operator device 504-506. Further, in **Figs. 5a****-b** it is shown how the main card 502 is positioned 90 degrees in relation to the daughter card 501. This is just an example of how the two boards can be placed, but it works well for the unit module 500, 520, according to the invention. The skilled person realises that the main card 502 may be positioned relative to the daughter card 501 in other ways than 90 degrees, for example, the main card 502 may be angled more or less than 90 degrees or be arranged parallel with the daughter card 501.

On the daughter card 501 a light pipe 508 can be mounted and can have Light - Emitting Diodes (LEDs) that can be used as indicators 509. If three LEDs are connected to the light pipe 508 with the colours Red, Green, Blue, they can be mixed together in an additive RGB colour model in which red, green, and blue light are added together in various ways reproducing a broad array of colours. With this technique many different colours can be created, not only the three colours connected to the light pipe 508. This is a new way of colouring, which has not been done before and which can hold much more information.

Referring to **Fig. 6****,** a block diagram of the embodiment of the unit module 500, 520 in **Fig. 5** according to the invention is shown. The AS-I slave network 407 described in **Fig. 4** is an exemplary embodiment comprising a communications terminal 620 used in the unit module 600. In **Fig. 6** one communications terminal 620 is shown, but the skilled person realises that one, two or more may be used. The communications terminal 620 is programmed to be an AS-I slave module, so the main card 602 becomes a slave to the control system 660 (e.g. PLC) that the unit module 600 is connected to. The communications terminal 620, being an AS-I slave module 620, and also the main card 602, has four inputs 621 and four outputs 622 that can be directly connected to the daughter card 601.

The inputs 621 are used for receiving signals 625a from the daughter card 601, for example from electrical switches 603a-b, and the outputs 622 are used for transmitting signals from the communications terminal 620 to the daughter card 601, for example to output means 609 on the daughter card 601. The switches 603a-b and the output means 609 will be further described below.

Other inputs as well as other outputs 622 at the communications terminal 620 are controlled by the common communications link 612, with means for transporting the signal 661 to or from output devices.

The four inputs 621 and the four outputs 622 can handle digital information that can be interpreted to be a 4 bit word, which has a numerical value of 0-15 and thereby 16 different states. In many cases it is sufficient with one communications terminal 620, but for example, in the case where the daughter card needs to manage more than 16 bits for the inputs 621 and the outputs 622, it may be done by arranging two communications terminals (or more) 620. The communications terminal may also intself be arranged for handling more than 16 bits for the inputs 621 and the outputs 622. The skilled person realises that as an alternative to the above described, a connector can be connected between the daughter card 601 and the main card 602, and then have receiving means as well as transmitting means between the two cards.

According to an aspect, instead of having parallel configurations as described above, the inputs and the outputs are arranged for serial communication.

A light switch or a plurality of light switches 603a-b, here two are shown, are each connected to one input of each AS-I slave module 620. A light switch 603a is controlled by one AS-I slave module 620. The AS-I slave module 620 is connected to the common communications link 612, so the signal 661 can be transported to the master of the AS-I network that is in the controller 660 (PLC), and in the controller the signal can be interpreted. After being interpreted in the AS-I master in the controller 660 (PLC), a signal 661 can go back to the AS-I slave module 620 or modules, and can therefore control the signal state of the outputs means 609 of the light pipe 608 mounted on the daughter card 601 via the communications link 612, via the inputs 621 and outputs 622, to and from the AS-I slave module 620, via connections 623-624 to the light pipe 608, to connections 651 via a holder 650 to output means 609. If a second pushbutton is mounted to the daughter card 601, another set of switch operator devices through a second light switch 603b are connected to an input of a second AS-I slave module, not shown, and a further signal can be interpreted by the remote master of the AS-I network by the controller 660 (e.g. PLC).

Referring to **Fig. 7a****-c** an extended use of an embodiment of the unit module, according to the invention is shown.

Referring to **Fig. 7a** the embodiment of the unit module 700, according to the invention is enclosed in a housing defining a hollow interior 703. A similar housing 703 could e.g. also be covering the unit module 500, 520 in **Fig.5****.** A daughter card 710 comprises a switch having a rotatable switch knob 701 which can be turned in fixed steps, an encoder plate 704, adapted to be mechanically movable with the rotable switch knob 701, and a partially enclosing encoder device 707. By turning the switch knob 701, constituting a manually operable actuator comprised in a switch operator device, the encoded plate 704 is rotated in the partially enclosing encoder device 707 that is arranged to interpret the positon of the encoded plate 704 and thus the setting of the switch knob 701. Further, a holder 702, a communications terminal 711, a communications link 706, and a main card 705 are shown. For this purpose, the partially enclosing encoder device 707 is arranged to partially enclose the encoder plate 704.

As in the previous example, there are four inputs 708 and four outputs 709. The inputs 708 are used for transferring signals from the daughter card 710 to the main card 705 and the communications terminal 711 on the main card 705, and the outputs 709 are used for transferring signals from the communications terminal 711 on the main card 705 to the daughter card 710, for example to output means 721, 732 on the dauhter card 710, below in the form of indicators. The four inputs 708 are here indicated with one arrow, and the four outputs 709 are indicated with another arrow.

The four inputs 708 and the four outputs 709 can handle digital information that can be interpreted to be a 4 bit word, which has a numerical value of 0-15 and thereby 16 different states. The daughter card 710 may be arranged for handling more than 16 different states, then there may of course be more than four outputs and four inputs, enabling transfer of more information between the daughter card 710 and the main card 705. In the following two examples of switch knobs that comprise ouput means in the form of indicators will be disclosed.

Referring to **Fig. 7b** a first design of an indicator switch knob 720 comprising an indicator 721 is shown. The indicator 721 can be e.g. a LED arrangement that can form a digit.

Referring to **Fig. 7c****,** a second design of an indicator switch knob 730 comprising an indicator 731 is shown. The indicator switch knob 701 can be turned into 16 different positions in steps as discussed with reference to Fig. 7a, resulting in 16 different output states. The indicator 731 comprises a LED arrangement that is arranged to indicate the present position of the indicator switch knob 730. In this example, a 5^{th} position 732 is indicated with a lit LED, corresponding to a fifth output state communicated via the encoded plate 704 in **Fig. 7a****.** Alternatively, an output state communicated via the encoded plate 704 may be indicated with all LED:s up to the number of the present state being lit, in this example with a fifth output state all LED:s from 1 to 5 would be lit.

With reference to **Fig. 8****,** a part 800 of an AS-Interface slave network is shown. A master 801 is here connected to a first slave 802 that is in the form of a communications terminal 802 as described for the examples above. The master 801 is here connected to a second slave 803 that is in the form of a lamp arrangement, a third slave 804 that is in the form of a sound signal device and a fourth slave 805 that is in the form of a motor relay arrangement that is adapted to control an electrical motor 806. The communications terminal 802 is here adapted to send a signal to the master 801, the signal corresponding to a certain state that indicates that a another slave should perform a certain action. The second slave 803, the third slave 804 and the fourth slave 805 are in this context constituted by output means or output devices.

For example, when the communications terminal 802 sends a signal to the master indicating that the electrical motor 806 should be turned on, the master 801 instructs the motor relay arrangement 805 to start the electrical motor 806.

The present invention is not limited to the examples above, but may vary freely within the scope of the appended claims. For example, all examples may be combined in any suitable manner, the communications terminal 802 described with reference to **Fig. 8** according to some aspects being any suitable communications terminal previously discussed, or any other suitable type of communications terminal that is adapted for the present invention.

Any other types of electrical switches with associated switch operator devices are of course conceivable, such as for example touch buttons, slide buttons or remote control buttons. Many other output means or output devices are conceivable as well, such as for example radio transmitters.

The inputs and the ouputs may handle any kind of digital information comprising at least a 4-bit word.

Generally, the daughter card is constituted by a first printed circuit board, and the main card is constituted by a second printed circuit board. These may in turn comprise two or more sub-circuit boards.

All switch parts may alse be referred to as contact parts, for example a switch operator device may also be referred to as a contact operator device, and an electrical switch may also be referred to as an electrical contact.

The examples have been directed towards an AS-Interface slave network, but other types of similar networks are of course conceivable for the manually actuatable integrated unit module according to the present invention.

The unit module is generally constituted by a manually actuatable integrated unit module.

## Claims

1. A system comprising at least one output device (406, 660) and a manually actuatable integrated unit module (500, 520, 600), said manually actuatable integrated unit module (500, 520, 600) comprising: a first printed circuit board (501, 601) comprising:
a switch operator device (504-506, 650), movable between at least a first and a second position;
at least a first electrical switch (503a, 603a), mounted on the surface of the first printed circuit board (501, 601) in such a way that movement of said switch operator (504-506, 650) between said at least first and second position will cause a change in mode of said at least first electrical switch (503a, 603a); and such a change of mode will cause a control signal (661) to be transferred via a common communications link (512,612)
associated with the manually actuatable unit module (500, 520, 600) for controlling the at least one output device (406, 660);
said manually actuatable integrated unit module (500, 520, 600) also comprising a second printed circuit board (502, 602) comprising at least one Actuator Sensor Interface slave module (620) mounted on the second printed circuit board (502, 602), the second printed circuit board is arranged for handling a first printed circuit board (501, 601),
said second printed circuit board (502, 602) having inputs (621) for receiving signals (625a) from said at least first electrical switch (503a, 603a) on said first printed circuit board (501, 601), and also having outputs (622) for transmitting signals from the slave module (620) to output means (609) on said first printed circuit board (501, 601),
where the inputs (621) are arranged to handle at least a 4-bit word, and where the outputs (622) are arranged to handle at least a 4-bit word,
wherein said change of mode of said at least first electrical switch (503a, 603a), activating said at least one slave module (620) in such a way that said control signal (661) on said associated
common communications link (512, 612) is produced, is adapted to control said at least one output device (406, 660), and **characterized in that** said at least one slave module (620) is connected to said at least one output device (406, 660), wherein said at least one output device (406, 660) is a master module (401) in a control system, such as a Programmable Logic Controller or a Microcomputer, controlling in a pre-determined and cyclic way said at least one slave module (620).

2. The system according to claim 1, **characterized in that** said common communications link (512, 612, 661) is an Actuator Sensor Interface bus.

3. The system according to any one of claims 1-2, **characterized in that** said change of mode is a change of level of a signal, and said level is activating said slave module (620).

4. The system according to claim 3, **characterized in that** said signal is an electrical voltage signal.

5. The system according to any one of claims 1-4, **characterized in that** means for receiving (621) receives no signal in said first position and receives any level or said signal in said second position.

6. The system according to any one of claims 1-5, **characterized in that** said switch operator device (504-506, 650) includes a manually operable actuator such as e.g. a button with a digital display (720), a manually operable selector switch (730), a manually operable key switch (103), or a manually operable pushbutton (101).

7. The system according to claim 6, **characterized in that** said manually operable actuator (101-104, 201-203, 301, 650, 720, 730) includes a pilot light (509, 609), having a light being determined by said associated output device (406, 660).

8. The system according to any one of claims 1-7, **characterized in that** said switch operator device (504-506, 650) comprises mechanical means (504-507) for moving between said first and second position; said mechanical means (504-507), having a slot (505), blocking light in said first position and passing light through said slot in said second position, where a change of the level of said electrical signal is produced in said at least first electrical switch (503a, 603a) when said light is passing through said slot (505).

9. The system according to any one of claims 1-8, **characterized in that** a light pipe (508), which is mounted on the first printed circuit board (501, 601), having Light-Emitting Diodes (509, 609), having at least two colours being mixed together in an additive RGB colour model added together in various ways reproducing a broad array of colours holding information.

10. The system according to any one of claims 1-9, wherein said manually actuatable integrated unit module (500, 520, 600) having a housing (703); and wherein
said switch operator device (504-506, 650) is partially enclosed within said housing (703), and the first printed circuit board (501, 601) and the second printed circuit board (502, 602) are mounted within said housing (703).

11. The system according to claim 10, wherein said switch operator device (504-506, 650) is connected to a manually operable actuator (720, 730) that comprises an indicator (721, 731).

12. The system according to any one of claims 10 or 11, wherein the manually actuatable integrated unit module (700) comprises a manually operable actuator in the form of a rotatable switch knob (701) which can be turned in fixed steps, an encoder plate (704), adapted to be mechanically movable with the rotatable switch knob (701), and a partially enclosing encoder device (707), where the encoder device (707) is arranged to interpret the position of the encoded plate (704) and thus the setting of the rotatable switch knob (701) when the rotatable switch knob (701) is turned.

13. A method of making a system comprising at least one output device (406, 660) and a manually actuatable integrated unit module (500, 520, 600), wherein a unit module is formed including:
a switch operator device (504-506, 650) movable between at least a first and a second position; a first printed circuit board (501, 601) and a second printed circuit board (502, 602) said method comprises:
mounting at least a first electrical switch (503a, 603a) on the surface of the first printed circuit board (501, 601) in such a way that movement of said switch operator (504-506, 650) between said at least first and second position will cause a change in mode of said at least first electrical switch (503a, 603a); and
such change of mode will cause a control signal (661) to be placed on an associated common communications link (512, 612) for controlling an associated output device,
**characterized in that the method comprises the steps of:**
mounting an Actuator Sensor Interface slave module (620) on a second printed circuit board (502, 602) that is used for handling a first printed circuit board (501, 601);
preassembling said first printed circuit board (501, 601) with said second printed circuit board (502, 602) by connecting said slave module (620) with inputs (621) for receiving signals (625a) from said at least
first electrical switch (503a, 603a), and means for transmitting outputs (622) from the slave module (620) to output means (609) on said first printed circuit board (501, 601), where the inputs (621) are arranged to handle at least a 4-bit word, and where the outputs (622) are arranged to handle at least a 4-bit word,
and preassembling said associated common communications link (512, 612) with said slave module (620) and said associated output device (406, 660) and **in that** said at least one slave module (620) is connected to said output device (406, 660), wherein said output device (406, 660) is a master module (401) in a control system, such as a Programmable Logic Controller or a Microcomputer controlling in a pre-determined and cyclic way said at least one slave module (620).

## Patentansprüche

1. System, umfassend zumindest eine Ausgangsvorrichtung (406, 660) und ein manuell betätigbares, integriertes Einheitsmodul (500, 520, 600), wobei das manuell betätigbare, integrierte Einheitsmodul (500, 520, 600) umfasst: eine erste Leiterplatte (501, 601), umfassend:
eine Schalterbedienungsvorrichtung (504-506, 650), die zwischen zumindest einer ersten und einer zweiten Position beweglich ist;
zumindest einen ersten elektrischen Schalter (503a, 603a), montiert auf der Oberfläche der ersten Leiterplatte (501, 601) in derartiger Weise, dass eine Bewegung der Schalterbedienung (504-506, 650) zwischen der zumindest ersten und zweiten Position eine Änderung in der Betriebsart des zumindest ersten elektrischen Schalters (503a, 603a) bewirkt; und eine solche Änderung in der Betriebsart bewirkt, dass ein Steuersignal (661) über eine gemeinsame Kommunikationsverbindung (512, 612) übertragen wird, die dem manuell betätigbaren, integrierten Einheitsmodul (500, 520, 600) zugehörig ist, um die zumindest eine Ausgangsvorrichtung (406, 660) zu steuern;
wobei das manuell betätigbare, integrierte Einheitsmodul (500, 520, 600) auch eine zweite Leiterplatte (502, 602) umfasst, die zumindest ein Actuator Sensor Interface Slave-Modul (620) umfasst, das auf der zweiten Leiterplatte (502, 602) montiert ist, wobei die zweite Leiterplatte zum Handhaben einer ersten Leiterplatte (501, 601) angeordnet ist,
wobei die zweite Leiterplatte (502, 602) Eingänge (621) zum Empfangen von Signalen (625a) von dem zumindest ersten elektrischen Schalter (503a, 603a) auf der ersten Leiterplatte (501, 601) aufweist, wie auch Ausgänge (622) zum Senden von Signalen vom Slave-Modul (620) zu Ausgangsmitteln (609) auf der ersten Leiterplatte (501, 601) aufweist,
wo die Eingänge (621) angeordnet sind, zumindest ein 4-Bit-Wort handzuhaben, und wo die Ausgänge (622) angeordnet sind, zumindest ein 4-Bit-Wort handzuhaben,
wobei die Änderung in der Betriebsart des zumindest ersten elektrischen Schalters (503a, 603a), die das zumindest eine Slave-Modul (620) derart aktiviert, dass das Steuersignal (661) auf der gemeinsamen Kommunikationsverbindung (512, 612) erzeugt wird, dazu ausgebildet ist, die zumindest eine Ausgangsvorrichtung (406, 660) zu steuern, **und dadurch gekennzeichnet, dass** das zumindest eine Slave-Modul (620) mit der zumindest einen Ausgangsvorrichtung (406, 660) verbunden ist, wobei die zumindest eine Ausgangsvorrichtung (406, 660) ein Mastermodul (401) in einem Steuersystem ist, wie eine speicherprogrammierbare Steuerung oder ein Mikrocomputer, das auf vorgegebene und zyklische Weise das zumindest eine Slave-Modul (620) steuert.

2. System nach Anspruch 1, **dadurch gekennzeichnet, dass** die gemeinsame Kommunikationsverbindung (512, 612, 661) ein Actuator Sensor Interface Bus ist.

3. System nach einem der Ansprüche 1-2, **dadurch gekennzeichnet, dass** die Änderung in der Betriebsart eine Änderung eines Signalpegels ist und der Pegel das Slave-Modul (620) aktiviert.

4. System nach Anspruch 3, **dadurch gekennzeichnet, dass** das Signal ein elektrisches Spannungssignal ist.

5. System nach einem der Ansprüche 1-4, **dadurch gekennzeichnet, dass** das Mittel zum Empfangen (621) kein Signal in der ersten Position empfängt und jeden Pegel oder das Signal in der zweiten Position empfängt.

6. System nach einem der Ansprüche 1-5, **dadurch gekennzeichnet, dass** die Schalterbedienungsvorrichtung (504-506, 650), ein manuell betätigbares Stellglied wie z.B. eine Taste mit einer digitalen Anzeige (720), einen manuell betätigbaren Wählschalter (730), einen manuell betätigbaren Tastenschalter (103) oder eine manuell betätigbare Drucktaste (101) enthält.

7. System nach Anspruch 6, **dadurch gekennzeichnet, dass** das manuell betätigbare Stellglied (101-104, 201-203, 301, 650, 720, 730) ein Pilotlicht (509, 609) mit einem Licht enthält, das durch die zugehörige Ausgangsvorrichtung (406, 660) bestimmt wird.

8. System nach einem der Ansprüche 1-7, **dadurch gekennzeichnet, dass** die Schalterbedienungsvorrichtung (504-506, 650) mechanische Mittel (504-507) zur Bewegung zwischen der ersten und zweiten Position umfasst, wobei die mechanischen Mittel (504-507) einen Schlitz (505) haben, der Licht in der ersten Position blockiert und in der zweiten Position Licht durch den Schlitz hindurchgehen lässt, wobei eine Änderung des Pegels des elektrischen Signals in dem zumindest ersten Schalter (503a, 603a) erzeugt wird, wenn das Licht durch den Schlitz (505) hindurchgeht.

9. System nach einem der Ansprüche 1-8, **dadurch gekennzeichnet, dass** eine Lichtröhre (508), die auf der ersten Leiterplatte (501, 601) montiert ist, Leuchtdioden (509, 609) aufweist, die zumindest zwei Farben haben, die in einem additiven RGB-Farbmodell gemischt sind, die auf verschiedene Weise addiert werden, wodurch eine breite Farbpalette wiedergegeben wird, die Informationen trägt.

10. System nach einem der Ansprüche 1-9, wobei das manuell betätigbare, integrierte Einheitsmodul (500, 520, 600) ein Gehäuse (703) hat; und wobei
die Schalterbedienungsvorrichtung (504-506, 650) teilweise in dem Gehäuse (703) eingeschlossen ist und die erste Leiterplatte (501, 601) und die zweite Leiterplatte (502, 602) in dem Gehäuse (703) montiert sind.

11. System nach Anspruch 10, wobei die Schalterbedienungsvorrichtung (504-506, 650) mit einem manuell betätigbaren Stellglied (720, 730) verbunden ist, das einen Indikator (721, 731) umfasst.

12. System nach einem der Ansprüche 10 oder 11, wobei das manuell betätigbare, integrierte Einheitsmodul (700) ein manuell betätigbares Stellglied in der Form eines drehbaren Schalterknopfs (701), der in fixierten Schritten gedreht werden kann, eine Codiererplatte (704), die ausgebildet ist, mechanisch mit dem drehbaren Schalterknopf (701) beweglich zu sein, und eine teilweise umschließende Codierervorrichtung (707) umfasst, wobei die Codierervorrichtung (707) angeordnet ist, die Position der Codiererplatte (704) und somit die Einstellung des drehbaren Schalterknopfs (701) zu interpretieren, wenn der drehbare Schalterknopf (701) gedreht wird.

13. Verfahren zum Erstellen eines Systems, umfassend zumindest eine Ausgangsvorrichtung (406, 660) und ein manuell betätigbares, integriertes Einheitsmodul (500, 520, 600), wobei ein Einheitsmodul gebildet wird, enthaltend:
eine Schalterbedienungsvorrichtung (504-506, 650), die zwischen zumindest einer ersten und einer zweiten Position beweglich ist; eine erste Leiterplatte (501, 601) und eine zweite Leiterplatte (502, 602), wobei das Verfahren umfasst:
Montieren zumindest eines ersten elektrischen Schalters (503a, 603a) auf der Oberfläche der ersten Leiterplatte (501, 601) derart, dass eine Bewegung der Schalterbedienungsvorrichtung (504-506, 650) zwischen der zumindest ersten und zweiten Position eine Änderung in der Betriebsart des zumindest ersten elektrischen Schalters (503a, 603a) bewirkt; und
eine solche Änderung in der Betriebsart bewirkt, dass ein Steuersignal (661) auf einer zugehörigen gemeinsamen Kommunikationsverbindung (512, 612) platziert wird, um eine zugehörige Ausgangsvorrichtung zu steuern,
**dadurch gekennzeichnet, dass das Verfahren die Schritte umfasst:**
Montieren eines Actuator Sensor Interface Slave-Moduls (620) auf einer zweiten Leiterplatte (502, 602), die zum Handhaben einer ersten Leiterplatte (501, 601) verwendet wird;
Vormontieren der ersten Leiterplatte (501, 601) mit der zweiten Leiterplatte (502, 602) durch Verbinden des Slave-Moduls (620) mit Eingängen (621) zum Empfangen von Signalen (625a) von dem zumindest ersten elektrischen Schalter (503a, 603a), und Mittel zum Senden von Ausgängen (622) vom dem Slave-Modul (620) zu Ausgangsmitteln (609) auf der ersten Leiterplatte (501, 601), wo die Eingänge (621) angeordnet sind, zumindest ein 4-Bit-Wort handzuhaben, und wo die Ausgänge (622) angeordnet sind, zumindest ein 4-Bit-Wort handzuhaben,
und Vormontieren der zugehörigen gemeinsamen Kommunikationsverbindung (512, 612) mit dem Slave-Modul (620) und der zugehörigen Ausgangsvorrichtung (406, 660), und dass das zumindest eine Slave-Modul (620) mit der Ausgangsvorrichtung (406, 660) verbunden ist, wobei die Ausgangsvorrichtung (406, 660) ein Mastermodul (401) in einem Steuersystem ist, wie eine speicherprogrammierbare Steuerung oder ein Mikrocomputer, das auf vorgegebene und zyklische Weise das zumindest eine Slave-Modul (620) steuert.

## Revendications

1. Système comprenant au moins un dispositif de sortie (406, 660) et un module unitaire intégré manuellement actionnable (500, 520, 600), ledit module unitaire intégré manuellement actionnable (500, 520, 600) comprenant une première carte de circuits imprimés (501, 601) comprenant :
un dispositif opérateur de commutation (504-506, 650) mobile entre au moins une première et une seconde position ;
au moins un premier commutateur électrique (503a, 603a) monté sur la surface de la première carte de circuits imprimés (501, 601) en sorte que le déplacement dudit opérateur de commutation (504-506, 650) entre lesdites au moins une première et une seconde position provoque un changement de mode dudit au moins un premier commutateur électrique (503a, 603a) ; et que ce changement de mode provoque le transfert d'un signal de commande (661) via une liaison de communication commune (512, 612) associée au module unitaire manuellement actionnable (500, 520, 600) pour commander le au moins un dispositif de sortie (406, 660) ;
ledit module unitaire intégré manuellement actionnable (500, 520, 600) comprenant également :
une seconde carte de circuits imprimés (502, 602) comprenant au moins un module asservi d'interface de capteur d'actionneur (620) monté sur la seconde carte de circuits imprimés (502, 602), la seconde carte de circuits imprimés étant agencée pour traiter une première carte de circuits imprimés (501, 601),
ladite seconde carte de circuits imprimés (502, 602) ayant des entrées (621) pour recevoir des signaux (625a) dudit au moins un premier commutateur électrique (503a, 603a) sur ladite première carte de circuits imprimés (501, 601) et ayant également des sorties (622) pour transmettre des signaux du module asservi (620) à des moyens de sortie (609) sur ladite première carte de circuits imprimés (501, 601),
dans lequel les entrées (621) sont agencées pour traiter au moins un mot de 4 bits et dans lequel les sorties (622) sont agencées pour traiter au moins un mot de 4 bits,
dans lequel ledit changement de mode dudit au moins un premier commutateur électrique (503a, 603a) activant ledit au moins un module asservi (620) de manière que ledit signal de commande (661) sur ladite liaison de communication commune associée (512, 612) soit produit, est adapté pour commander ledit au moins un dispositif de sortie (406, 660) et **caractérisé en ce que** ledit au moins un module asservi (620) est connecté audit au moins un dispositif de sortie (406, 660), dans lequel ledit au moins un dispositif de sortie (406, 660) est un module maître (401) dans un système de commande, tel qu'un contrôleur à logique programmable ou un micro-ordinateur, commandant de manière prédéterminée et cyclique ledit au moins un module asservi (620).

2. Système selon la revendication 1, **caractérisé en ce que** ladite liaison de communication commune (512, 612, 661) est un bus d'interface de capteur d'actionneur.

3. Système selon l'une quelconque des revendications 1 et 2, **caractérisé en ce que** ledit changement de mode est un changement de niveau d'un signal et ledit niveau active ledit module asservi (620).

4. Système selon la revendication 3, **caractérisé en ce que** ledit signal est un signal de tension électrique.

5. Système selon l'une quelconque des revendications 1 à 4, **caractérisé en ce que** ledit moyen de réception (621) ne reçoit pas de signal dans ladite première position et reçoit un niveau quelconque ou ledit signal dans ladite seconde position.

6. Système selon l'une quelconque des revendications 1 à 5, **caractérisé en ce que** ledit dispositif opérateur de commutation (504-506, 650) comprend un actionneur manuellement actionnable tel que, par exemple, un bouton avec un afficheur numérique (720), un commutateur sélecteur manuellement actionnable (730), un manipulateur manuellement actionnable (103) ou un bouton poussoir manuellement actionnable (101).

7. Système selon la revendication 6, **caractérisé en ce que** ledit actionneur manuellement actionnable (101-104, 201-203, 301, 650, 720, 730) comprend une lampe pilote (509, 609) ayant une lumière déterminée par ledit dispositif de sortie associé (406, 660).

8. Système selon l'une quelconque des revendications 1 à 7, **caractérisé en ce que** ledit dispositif opérateur de commutation (504-506, 650) comprend des moyens mécaniques (504-507) pour se déplacer entre lesdites première et seconde positions ; lesdits moyens mécaniques (504-507) ayant une fente (505) bloquant la lumière dans ladite première position et laissant passer la lumière à travers ladite fente dans ladite seconde position, où un changement du niveau dudit signal électrique est produit dans ledit au moins un premier commutateur électrique (503a, 603a) lorsque ladite lumière passe à travers ladite fente (505).

9. Système selon l'une quelconque des revendications 1 à 8, **caractérisé en ce qu'**un conduit de lumière (508), qui est monté sur la première plaque de circuits imprimés (501, 601), ayant des diodes électroluminescentes (509, 609), ayant au moins deux couleurs qui sont mélangées ensemble dans un modèle de couleurs RVB additif ajouté conjointement de diverses manières en reproduisant un large réseau de couleurs contenant des informations.

10. Système selon l'une quelconque des revendications 1 à 9, dans lequel ledit module unitaire intégré manuellement actionnable (500, 520, 600) a un boîtier (703) ; et dans lequel ledit dispositif opérateur de commutation (504-506, 650) est partiellement enserré dans ledit boîtier (703) et la première plaque de circuits imprimés (501, 601) et la seconde plaque de circuits imprimés (502, 602) sont montées dans ledit boîtier (703).

11. Système selon la revendication 10, dans lequel ledit dispositif opérateur de commutation (504-506, 650) est connecté à un actionneur manuellement actionnable (720, 730) qui comprend un indicateur (721, 731).

12. Système selon l'une quelconque des revendications 10 ou 11, dans lequel le module unitaire intégré manuellement actionnable (700) comprend un actionneur manuellement actionnable sous la forme d'un bouton de commutation rotatif (701) qui peut être soumis à une rotation par étapes fixes, une plaque de codage (704) qui est à même de pouvoir être déplacée mécaniquement avec le bouton de commutation rotatif (701) et un dispositif de codage à enserrement partiel (707), où le dispositif de codage (707) est agencé pour interpréter la position de la plaque de codage (704) et donc le réglage du bouton de commutation rotatif (701) lorsque le bouton de commutation rotatif (701) est tourné.

13. Procédé de fabrication d'un système comprenant au moins un dispositif de sortie (406,660) et un module unitaire intégré manuellement actionnable (500, 520, 600), dans lequel un module unitaire est formé, comprenant :
un dispositif opérateur de commutation (504-506, 650) déplaçable entre au moins une première et une seconde position ; une première plaque de circuits imprimés (501, 601) et une seconde plaque de circuits imprimés (502, 602), ledit procédé comprenant :
le montage d'au moins un premier commutateur électrique (503a, 603a) sur la surface de la première carte de circuits imprimés (501, 601) en sorte que le déplacement dudit opérateur de commutation (504-506, 650) entre lesdites au moins une première et une seconde position provoque un changement de mode dudit au moins un premier commutateur électrique (503a, 603a) ; et
ce changement de mode amènera un signal de commande (661) à placer sur une liaison de communication commune associée (512, 612) pour commander un dispositif de sortie associé,
**caractérisé en ce que le procédé comprend les étapes consistant à :**
monter un module asservi d'interface de capteur d'actionneur (620) sur une seconde plaque de circuits imprimés (502, 602) qui est utilisée pour traiter une première carte de circuits imprimés (501, 601) ;
pré-assembler ladite première carte de circuits imprimés (501, 601) avec ladite seconde carte de circuits imprimés (502, 602) en connectant ledit module asservi (620) avec des entrées (621) pour recevoir des signaux (625a) provenant dudit au moins un premier commutateur électrique (503a, 603a) et des moyens pour transmettre des sorties (622) venant du module asservi (620) à des moyens de sortie (609) sur ladite première plaque de circuits imprimés (501, 601), où les entrées (621) sont agencées pour traiter au moins un mot de 4 bits et où les sorties (622) sont agencées pour traiter au moins un mot de 4 bits, et
pré-assembler ladite liaison de communication commune associée (512, 612) avec ledit module asservi (620) et ledit dispositif de sortie associé (406, 660) et dans lequel ledit au moins un module asservi (620) est connecté audit dispositif de sortie (406, 660), dans lequel ledit dispositif de sortie (406, 660) est un module maître (401) dans un système de commande, tel qu'un contrôleur à logique programmable ou un micro-ordinateur commandant de manière prédéterminée et cyclique ledit au moins un module asservi (620).
